# EUROPEAN PATENT SPECIFICATION

(11) **EP 2 924 707 B1**
(45) Date of publication and mention of the grant of the patent: **28.02.2024**
(21) Application number: 14003366.3
(22) Date of filing: 03.09.2014
(51) Int. Cl.: H01J 37/22, G01J 3/44, H01J 37/26, G01N 21/65, G01Q 30/02

(54) **Raman microscope and electron microscope analytical system**
Raman-Mikroskop und Elektronenmikroskopanalysesystem
Microscope Raman et système d'analyse par microscope électronique

(30) Priority: 26.03.2014 CZ 20140184
(43) Date of publication of application: 30.09.2015
(73) Proprietor: Tescan Group, a.s., Brno - Kohoutovice 623 00 (CZ); Witec GmbH, 89081 Ulm (DE)
(72) Inventor: Jiruse, Jaroslav, Blansko (CZ); Hollricher, Olaf, Neu-Ulm (DE); Hanicinec, Martin, Uherské Hradiste (CZ)
(74) Representative: Sawodny, Michael-Wolfgang

(56) References cited:
- EP-A1- 2 469 253
- EP-A2- 2 772 334
- JP-A- 2014 044 796
- US-A1- 2003 053 048
- US-A1- 2007 057 184
- US-A1- 2008 262 324
- US-A1- 2010 128 263
- PITT G D ET AL: "Engineering aspects and applications of the new Raman instrumentation", IEE PROCEEDINGS: SCIENCE, MEASUREMENT AND TECHNOLOGY, IEE, STEVENAGE, HERTS, GB, vol. 152, no. 6, 1 November 2005 (2005-11-01), pages 241-318, XP002483939, ISSN: 1350-2344, DOI: 10.1049/IP-SMT:20050015
- JIRUSE JAROSLAV ET AL: "Integrating focused ion beam-scanning electron microscope with confocal Raman microscope into a single instru", JOURNAL OF VACUUM SCIENCE, AMERICAN INSTITUTE OF PHYSICS, 2 HUNTINGTON QUADRANGLE, MELVILLE, NY 11747, vol. 32, no. 6, 22 October 2014 (2014-10-22), pages 1-6, XP012191116, ISSN: 2166-2746, DOI: 10.1116/1.4897502 [retrieved on 1901-01-01]
- Y Aksenov ET AL: "Raman Microscopy in an electron microscope: combining chemical and morphological analyses", , 1 January 2003 (2003-01-01), XP055396633, Retrieved from the Internet: URL:https://core.ac.uk/download/pdf/114571 69.pdf [retrieved on 2023-02-09]

## Description

### Field of the invention

The submitted invention involves the system with Raman microscope and the electron microscope for analysis of specimen located in the vacuum chamber.

### Background of the invention

The current applications of electron microscopes require continuously increasing analytical capabilities of the apparatus. The important data on the examined sample are obtained, for instance, by a method of electron back scattered diffraction, by energy or wavelength-dispersive X-ray spectroscopy but also by optical methods such as the Raman spectroscopy. Connection of Raman spectroscopy and electron microscopy allows to analyze the chemical compound of certain sample area thanks to the Raman scattering of the incident light while utilizing the high resolution of transmission or scanning electron microscope, which is much higher, than the resolving power of light.

Among technical applications are some systems known in which the electron microscope and Raman microscope are parallel next to each other as it is apparent in the documentation JP H06347405, EP 2469253, US 5811804, US 2007057184. In all of these systems it is necessary, during analyzing by electron microscope and Raman microscope, to move the sample between the optical axes of particular systems. That brings several disadvantages, foremost the complicated and slow adjustment of the sample position making more difficult to achieve the sample analysis at the same precise point in both microscopes.

This disadvantage is removed in the systems with the coincidental set up of optical axes of electron microscope and Raman spectroscopy system such as JP H06347343 that describes the system for measurement stress distribution on the sample and JP 2010190595 in which the navigation at the specimen is assured by burning the marks using laser. Both of these documents, together with those described above, leave the disadvantage of the necessity to set the incident point of the light beam for Raman spectroscopic analysis by moving the sample stage. This yields the disadvantage that behavior of the piezo-manipulator depends on a specimen weight which is more significant especially at higher speeds of the sample stage. Further with every position change towards the optical axis of the system with Raman spectroscopy also the position towards optical axes of other analytical equipment changes and in these it is often necessary to adjust their directions and calibrate. This disadvantage arises especially in Raman mapping of a specific area.

Further the systems that use the mirrors exist which direct and focus the light beam at the sample and also include the aperture for concomitant using of an electron beam which goes through the aperture and is directed at the same place in the sample. Such a system has been described for instance in the document US 6885445, EP 1412796 and FR 2596863 which, the same as the systems stated above, are not able to set the point of the impinging light beam for Raman spectroscopic analysis in other way than by moving the sample itself. If the mirror is used, usually parabolic one, by focusing the light beam at the sample a lower quality of the picture and a bigger spot size is usually achieved compared to using the lenses. These instruments commonly reach the resolution of only 2-5 micrometers, which is incomparably worse than in typical stand-alone Raman microscopes. Another disadvantage is much smaller field of view for the navigation on the sample than by using of optical objective.

With concurrent use of the electron beam, the mirror with aperture uses the system described in US 7139071 and it has the same disadvantages in that case. By defocusing the light beam hitting the sample, this system allows scanning in a plane perpendicular to the axis of the laser beam. Scanning in one direction is achieved with a moveable plate with a slit in the path of the scattered light of the spectroscopic device. In the other direction this system allows scanning by using a detector which can create the virtual slit by selecting of certain lines of pixels. As the incident light beam needs to be defocused for scanning, the light intensity impinging the analyzed point is significantly reduced and the low intensity of the scattered light worsens the analytical ability of this system. There is a lower useful signal to noise ratio, a linger time needed for analysis and therefore, the system is useful for some applications.

It can be further mentioned that the inspection system for semi-conductors in the document JP 2001330563 that uses galvanometric scanning mirror that is able to deflect the laser beam at a plane perpendicular to the laser beam axis. This maintains disadvantage to focus by the sample stage. This means to move the sample stage to set the point where the light beam impinges the sample in the direction of the light beam axis. Another disadvantage of this system is the fact that the laser beam is directed out of the objective optical axis in the course of deflection and that increases the spherical aberration of the system.

There are also some systems known, as in document JP 2014044796, in which the optical microscope and charged particle optical tube, that irradiates a sample with a primary charged particle beam, are positioned opposite to each other and the sample is placed between them. Such systems do not allow observing the same spot of the example bigger or non-transparent samples by both devices simultaneously, because the spot is always unreachable for one of them.

Further relevant prior art is known from US 2003/053048 A1. This document discloses that the optical system directs the input laser to a parabolic mirror (18) which focus the light on a spot of the sample. Nowhere in the application US 2003/053048 A1 it is described that by moving the mirror (18) a two dimensional scan of the laser light on the sample is performed.

### Summary of the invention

In accordance with the present invention, there is provided a Raman microscope and electron microscope analytical system comprising a vacuum chamber, a chamber stage to support a sample in a vacuum chamber, an electron microscope having electron microscope optical axis for producing electron beam and directing it to the sample and a Raman microscope that comprises a spectroscopy system, a scattered light detector, an illumination source, a light beam forming optics and an optical objective lens having Raman microscope optical axis, said optical objective lens is configured to focus received light beam at the sample so as to create a light spot at the sample and induce scattered light, wherein said optical objective lens is connected to the optical objective lens manipulator that allows movement of the optical objective lens in at least first direction along the Raman

microscope optical axis, wherein said optical objective lens manipulator (17) is configured to move the optical lens (11) and to scan a specific two dimensional sample (3) area by the light spot (14) of the light beam (12).

Advantageously, the optical objective lens is connected to three-dimensional optical objective lens manipulator.

In another embodiement, the analytical system further comprises the confocal means for reducing scattered light from non-desired planes out of the focal point. Further benefits and advantages of the present invention will become apparent after a careful reading of the description of preferred embodiements with appropriate reference to the accompanying drawings.

### Brief description of the drawings

Fig. 1 is a schematic picture of the Raman microscope and electron microscope analytical system in accordance with the preferred embodiements of the present invention.
Fig. 2 is a schematic picture of the objective lens in a first position set by the objective manipulator Fig. 3 is a schematic picture of the objective lens in a second position set by the objective manipulator
Fig. 4 is a schematic picture of the Raman microscope and electron microscope analytical system example in the alternative arrangement of analytical instruments.

### Description of Preferred Embodiments

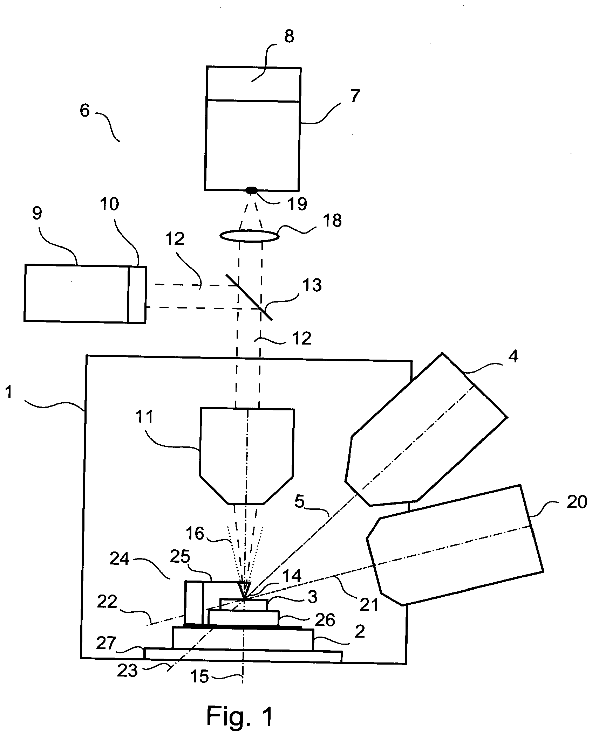

The example of preferred embodiment of the analytical system with Raman microscope and electron microscope is schematically drawn in Fig. 1. It comprises of a vacuum chamber 1 that serves for preserving the vacuum needed for function of the instruments using charged particles and it also forms the support for other system parts such as the chamber stage 2. The chamber stage 2 allows positioning of the sample 3 and is attached to vacuum chamber 1 by a movable stage manipulator 27. The stage manipulator 27 can function due to piezoelectric effect or can be actuated by a motor. The chamber stage 2 can be moved in all three axes and it also can rotate along at least one axis. Besides supporting of the sample 3 the stage manipulator 27 can be used to position the sample 3 for analysis of certain point of sample 3 by some analytical instrument or also it can move the sample 3 to another analytical instrument. For those skilled in this area of technology, there are other ways to move the chamber stage 2, for instance manual, hydraulic or pneumatic, it is not excluded that the chamber stage 2 is even firmly connected with the vacuum chamber 1 or it is the part of the vacuum chamber 1. For instance on geological applications or in semi-conductor industry, the chamber stage 2 can be alternatively replaced by a conveyor carrying samples 3 and moving them in the vacuum chamber 1 space.

There is also electron microscope 4 connected to the vacuum chamber 1 which is in this preferred embodiment set as the scanning electron microscope 4. The electron microscope 4 that has the electron microscope optical axis 23 is adjusted mainly to generate the electron beam 5, to direct and focus it at the sample 3 for interaction with the sample 3 and further detection of the products of this interaction such as secondary electrons, backscattered electrons, auger electrons, transmitted electrons, X-rays and photons. In the alternative embodiment, the electron microscope is set as the transmission electron microscope when there are for example transmitted electrons as the product of the interaction. There are many known detectors converting some of the mentioned products into electrical signal. These detectors are well known to skilled professionals familiar with this technology so there is no need to further explain. The high resolution that is achieved by the electron microscope 4 and the interaction of electrons with the sample 3 followed by the detection of products of such interactions provides much information of the analyzed sample 3. Despite of that there is a number of characteristics that cannot be reliably analyzed by electron microscope such as chemical bonds and identification of molecules present.

That is why the system includes also Raman microscope 6 that is suitable for identifying the molecules. The analytical system with Raman microscope and electron microscope uses a synergy based for example on the fact that the Raman microscope analysis of the sample 3, the chemical composition of the specific point of the sample 3 can be assessed and the electron microscope 4 provides the resolution much higher than resolution limit of light. Further it is possible to correlate Raman analysis of the sample 3 with energy dispersive X-ray spectroscopy EDX or wave dispersive X-ray spectroscopy WDX, which are techniques for detecting the elemental composition of the sample 3 using the electron beam. The elemental mapping of the sample 3 based on EDX or WDX analysis eases the identification of Raman spectra. Further it is possible to use the navigation on the sample 3 by means of electron microscope 4 which is, for its large field of view, more convenient than commonly used navigations by the light microscope in which, due to higher resolution, a larger numeric aperture is required, resulting usually in a smaller field of view. In the advantageous description in Fig.1, the Raman microscope 6 includes also a spectrometric system 7 that is attached to the vacuum chamber 1. In some other implementation the spectroscopic system can be attached via the optic fiber due to more convenient space configuration (not on the figure). Spectroscopic system 7 is in the convenient implementation consisting of the set of optical elements, grid and detector of scattered light 8 that consists of CCD chip. Alternatively, some other equipment that is able to change the light signal into the electrical signal can be used.

The other part of Raman microscope 6 is light source 9 and light beam forming optics 10 that are attached to vacuum chamber. The light source 9 is the solid state laser source type Nd:YAG. Alternatively other laser sources can be used with the wave length from ultra-violet to near infra-red, such as gas laser Helium-neon. According to the convenient construction Fig. 1 the laser source 9 and light beam forming optics 10 are located outside of the vacuum chamber 1 and outside the optical axis of the optical objective lens 11 which optical axis is further named as the Raman microscope optical axis 15. The optical objective lens 11 can be done for instance as a separate lens or the set of optical lenses. Light beam 12 is directed to the optical objective lens 11 via a view port (not in the figure) in the wall of the vacuum chamber 1. Directing of the light beam 12 can be achieved for instance by semi-permeable mirror 13 as stated in Fig. 1 or by other optical elements used for the reflection or the deflection of light. In some other implementation there can be light source 9 and the light beam forming optics 10, for reason of more convenient spatial configuration, attached for instance by the optic fiber (not in the figure) or the light source 9 and light beam forming optics 10 can be placed in the vacuum chamber 1. In alternative setting, the light source 9, light beam forming optics 10, light beam 12, the view port and optical objective lens 11 are set in the Raman microscope optical axis 15.

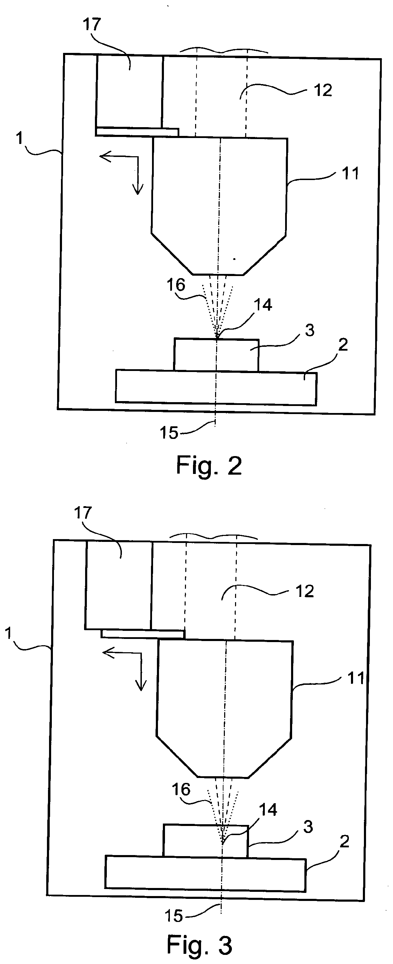

The optical objective lens 11 is adjusted to focus the coming light beam 12 to the focal point on sample 3 to create the light spot 14 at this sample 3 and to induce scattered light 16. The light spot 14 on the sample 3 can be created on the surface of sample 3 as illustrated on Fig. 2 or in the sample 3 bulk as illustrated on Fig. 3. Both Fig. 2 and Fig. 3 show the light beam 12 that has to be homogeneous and wide enough to prevent significant intensity changes of the light spot 14 on specimen 3 when objective manipulator 17 moves the optical objective lens 11. An arrangement allows the objective manipulator 17 to be two-dimensional which assures the motion of optical objective lens 11 in the first direction along the Raman microscope optical axis 15 and in the other direction the motion of optical objective lens 11 perpendicular to the Raman microscope optical axis 15. In such setting, the Raman analysis of a chosen point on the sample 3 can be done in the plane parallel to the Raman microscope optical axis 15. In the convenient setting, the objective manipulator 17 is adjusted to scan a specific two-dimensional area of the specimen 3 in this plane. In the course of that, the area is being captured point by point, where each point includes the entire spectrum. Measured spectrums are recorded and the image is created according these data. In the convenient setting shown on Fig. 2 and Fig. 3, the objective manipulator 17 is attached to the vacuum chamber 1 on one side and to the optical objective lens 11 on the other side. In this setting, the objective manipulator 17 is made as a three-dimensional objective manipulator 17, and thus allows performing the Raman analysis of the chosen point on sample 3 at any point on the sample 3 surface or in the bulk of the sample 3. In the convenient setting, the objective manipulator 17 is adjusted for scanning a specific two-dimensional or three-dimensional area of the sample 3. The objective manipulator consists for example of several piezoelectric components which are deformed after application of voltage and thus causing the movement of optical objective lens 11 in two or in all three axes. Such objective manipulator 17 is advantageous for its life span, the speed and precision. Alternatively the objective manipulator 17 can be driven by motor, hydraulic and pneumatic equipment. Moving of the optical objective lens 11 itself has a number of advantages, such as independence of properties of the objective manipulator 17 on the weight of the sample 3 because the weight of the optical objective lens 11 is always the same; further, the position of the sample 3 can be maintained stabile when using other connected analytical instruments, even when the scanning is performed by Raman microscope 6.

The best results are attained when the system is confocal, as shown in Fig. 1. In the convenient setting, this can be achieved by adjusting the optical objective lens 11 for collecting and directing scattered light 16 to confocal means that is made as confocal means optics 18 and pinhole 19. Confocal means optics 18 can be realized by using said optical objective lens 11, by a mirror or by a lens. Pinhole 19 can be realized by using the entrance pupil of optical fiber, using an aperture, a slit or segment of the CCD chip of the scattered light detector 8, as is apparent to any professional familiar with this technical field. Confocal system thus reduces the light from unwanted out-of-focus planes, which allows passage of the scattered light 16 with the largest portion of the light exactly from the focal point of the light beam 12. The scattered light 16 is detected with the scattered light detector 8 and is spectrally resolved in the spectroscopy system 7.

The optical objective lens 11 adjustable by means of three-dimensional manipulator of the objective lens 17 in confocal setting allows not only two-dimensional mapping of the sample 3 surface but also creating three-dimensional data set by means of three-dimensional mapping. Three-dimensional mapping is useful for instance in mapping topographically indented surface and also in 3D tomography of a sample 3 that is transparent to a laser light. Such tomography is hugely advantageous because it is not destructive. The other solution of creating a 3D view can be to equip the analytical system with ion beam column 20. Ion beam column 20 serves for creating a focused ion beam 21 and directing it to the sample 3. With this focused ion beam 21 it is possible to mill the surface of the sample 3 the layer after layer and to analyze newly created surfaces. Such 3D tomography is destructive but usable also on samples 3 non-transparent to the laser.

Various applications and the spatial possibilities of more complicated equipment can require various spatial settings of individual components of the analytical system, that is the electron microscope 4, Raman microscope 6 and ion beam column 20 that can be organized parallel next to each other or they can be oriented in an angle so that their beams can meet at the same spot on the sample 3.

It is advantageous that ion beam column optical axis 22 is in angle to the electron microscope optical axis 23 so that the ion beam 21 and the electron beam 5 are able to meet at the same spot at the sample 3. This is advantageous when modifying of the sample 3 by ion beam 21 and with concurrent imaging of the sample 3 by means of electron microscope 4 without any need to move the sample 3.

In another embodiment the Raman microscope optical axis 15 is in an angle to the electron microscope optical axis 23 so that the light beam 12 and the electron beam 5 are able to meet at the same spot of the sample 3. Thus it is possible to correlate the image of the electron microscope 4 with Raman analysis of the same area of the sample 3 without any need to move the sample 3.

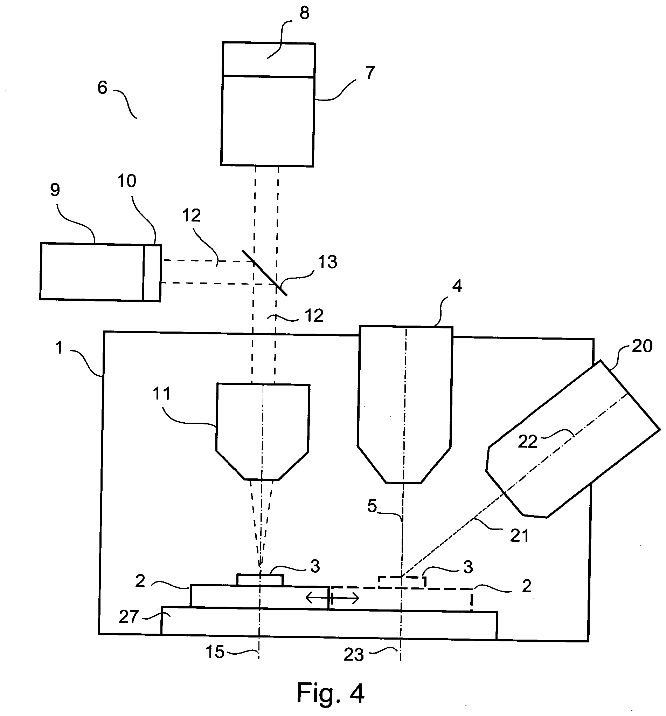

The advantages of both prior settings are joined in the spatial arrangement where the ion beam column optical axis 22 and the electron microscope optical axis 23 are in angle to the Raman microscope optical axis 15 so that the ion beam 21, the electron beam 5 and the light beam 12 are able to meet at the same spot at the sample 3. Moreover there is beneficial spatial arrangement, in which the chamber stage 2 is connected to stage manipulator 27 configured to move the sample 3 from the first position where the Raman microscope optical axis 15 intersects the sample 3 to the second position where the electron microscope optical axis 23 intersects the sample 3 as shown on Fig. 4. Advantageously the Raman microscope optical axis 15 and the electron microscope optical axis 23 are substantially parallel to each other. In such setting we avoid specimen relocation that is less precise and more difficult and time consuming due to need to provide tilt as well as the direct motion in one direction.

The Raman microscope and electron microscope analytical system described above can be further equipped with scanning probe microscope 24 to achieve very high topographical resolution. Scanning probe microscope 24 comprises the scanning probe microscope cantilever 25 and the scanning probe microscope stage 26 placed on the chamber stage 2. In one embodiment there is the scanning probe microscope cantilever 25 movable to provide fine scanning of the sample 3. It is advantage that the scanning probe microscope cantilever 25 movement is independent on the movement of the optical objective lens 11. This allows simultaneous Raman and scanning probe microscope analysis contrary to systems those uses sample 3 movements for Raman analysis. In another embodiment there is the scanning probe microscope stage 26 movable to provide fine scanning of the sample 3.

Although the invention has been explained in relation to its preferred embodiments, it is to be understood that many other possible modifications and variations can be made without departing from the scope of the present invention. It is, therefore, contemplated that the appended claims will cover such modifications and variations that fall within the scope of the invention which is defined by the appended claims.

### Reference Signs List

1 vacuum chamber
2 chamber stage
3 sample
4 electron microscope
5 electron beam
6 Raman microscope
7 spectroscopy system
8 scattered light detector
9 illumination source
10 light beam forming optics
11 optical objective lens
12 light beam
13 mirror
14 light spot
15 Raman microscope optical axis
16 scattered light
17 objective manipulator
18 confocal means optics
19 pinhole
20 ion beam column
21 ion beam
22 ion beam column optical axis
23 electron microscope optical axis
24 scanning probe microscope
25 scanning probe microscope cantilever
26 scanning probe microscope stage
27 stage manipulator

## Claims

1. A Raman microscope and electron microscope analytical system comprising a vacuum chamber (1), a chamber stage (2) to support a sample (3) in the vacuum chamber (1), an electron microscope (4) having an electron microscope optical axis (23) for producing an electron beam (5) and directing it to the sample (3) and a Raman microscope (6) that comprises a spectroscopy system (7), a scattered light detector (8), an illumination source (9), a light beam forming optics (10) and an optical objective lens (11) having a Raman microscope optical axis (15), an optical objective lens (11) is configured to focus a received light beam (12) at the sample (3) so as to create a light spot (14) at the sample (3) and induce scattered light (16), wherein the optical objective lens (11) is connected to an optical objective lens manipulator (17) that is configured to move the optical objective lens (11) in at least two dimensions, a first direction along the Raman microscope optical axis (15) and a second direction in a plane perpendicular to the Raman microscope optical axis (15),
**characterized in that**
the optical objective lens manipulator (17) is configured to move the optical lens (11) and to scan a specific two dimensional sample (3) area by the light spot (14) of the light beam (12).

2. The Raman microscope and electron microscope analytical system according to claim 1
**characterized in that**
the analytical system further comprises confocal means for reducing scattered light (16) from non-desired planes out of a focal point.

3. The Raman microscope and electron microscope analytical system according to any of the preceding claims,
**characterized in that**
the analytical system further comprises an ion beam column (20) having a ion beam column optical axis (22) for producing an ion beam (21) and directing it to the sample (3).

4. The Raman microscope and electron microscope analytical system according to claim 3,
**characterized in that**
the ion beam column optical axis (22) is at a non-zero angle to the electron microscope optical axis (23) so that the ion beam (21) and the electron beam (5) are able to meet at the same spot at the sample (3).

5. The Raman microscope and electron microscope analytical system according to claim 3,
**characterized in that**
the ion beam column optical axis (22) and the electron microscope optical axis (23) are in a non-zero angle to the Raman microscope optical axis (15) so that the ion beam (21), the electron beam (5) and the light beam (12) are able to meet at the same spot at the sample (3).

6. The Raman microscope and electron microscope analytical system according to any of claims 1 to 3,
**characterized in that**
the Raman microscope optical axis (15) is at a non-zero angle to the electron microscope optical axis (23) so that the light beam (12) and the electron beam (5) are able to meet at the same spot at the sample (3).

7. The Raman microscope and electron microscope analytical system according to any of claims 1 to 5,
**characterized in that**
the chamber stage (2) is connected to a stage manipulator (27) which is configured to move the sample (3) from the first position where the Raman microscope optical axis (15) intersects the sample (3) to the second position where the electron microscope optical axis (23) intersects the sample (3).

8. The Raman microscope and electron microscope analytical system according to claim 4,
**characterized in that**
the Raman microscope optical axis (15) and the electron microscope optical axis (23) are parallel to each other.

9. The Raman microscope and electron microscope analytical system according to any of the preceding claims,
**characterized in that**
the analytical system further comprises a scanning probe microscope (24) comprising a scanning probe microscope cantilever (25) and a scanning probe microscope stage (26) placed on the chamber stage.

10. The Raman microscope and electron microscope analytical system according to claim 9,
**characterized in that**
the scanning probe microscope cantilever (25) is movable to provide fine scanning of the sample (3).

11. The Raman microscope and electron microscope analytical system according to claim 9,
**characterized in that**
the scanning probe microscope stage (26) is movable to provide find scanning of the sample (3).

12. The Raman microscope and electron microscope analytical system according to any of the preceding claims,
**characterized in that**
the electron microscope (4) is a scanning electron microscope comprising at least one detector for detecting one or more of the group of secondary electrons, backscattered electrons, auger electrons, transmitted electrons, X-rays and photons.

13. The Raman microscope and electron microscope analytical system according to any of the claims 1 to 12,
**characterized in that**
the electron microscope (14) is a transmission electron microscope (4) comprising at least one detector for detecting transmitted electrons.

## Patentansprüche

1. Raman-Mikroskop- und Elektronenmikroskopanalysesystem, umfassend eine Vakuumkammer (1), eine Kammerplattform (2) zum Tragen einer Probe (3) in der Vakuumkammer (1), ein Elektronenmikroskop (4) mit einer optischen Elektronenmikroskopachse (23) zum Erzeugen eines Elektronenstrahls (5) und Leiten von diesem zur Probe (3) und ein Raman-Mikroskop (6), das ein Spektroskopiesystem (7) umfasst, einen Streulichtdetektor (8), eine Beleuchtungsquelle (9), eine Lichtstrahl bildende Optik (10) und eine Objektivlinse (11) mit einer optischen Raman-Mikroskopachse (15), wobei eine optische Objektivlinse (11) dazu konfiguriert ist, einen empfangenen Lichtstrahl (12) an der Probe (3) zu fokussieren, um so einen Lichtpunkt (14) an der Probe (3) zu erzeugen und Streulicht (16) zu induzieren, wobei die optische Objektivlinse (11) mit einem Manipulator (17) der optischen Objektivlinse verbunden ist, der dazu konfiguriert ist, die optische Objektivlinse (11) in mindestens zwei Dimensionen zu bewegen, einer ersten Richtung entlang der optischen Raman-Mikroskopachse (15) und einer zweiten Richtung in einer Ebene senkrecht zur optischen Raman-Mikroskopachse (15),
**dadurch gekennzeichnet, dass**
der Manipulator (17) der optischen Objektivlinse dazu konfiguriert ist, die optische Linse (11) zu bewegen und einen spezifischen zweidimensionalen Bereich der Probe (3) durch den Lichtpunkt (14) des Lichtstrahls (12) abzutasten.

2. Raman-Mikroskop- und Elektronenmikroskopanalysesystem nach Anspruch 1,
**dadurch gekennzeichnet, dass**
das Analysesystem ferner ein konfokales Mittel zum Reduzieren von Streulicht (16) aus nicht gewünschten Ebenen aus einem Brennpunkt umfasst.

3. Raman-Mikroskop- und Elektronenmikroskopanalysesystem nach einem der vorhergehenden Ansprüche,
**dadurch gekennzeichnet, dass**
das Analysesystem ferner eine Ionenstrahlsäule (20) mit einer optischen Ionenstrahlsäulenachse (22) zum Erzeugen eines lonenstrahls (21) und Leiten von diesem zur Probe (3) umfasst.

4. Raman-Mikroskop- und Elektronenmikroskopanalysesystem nach Anspruch 3,
**dadurch gekennzeichnet, dass**
sich die optische Ionenstrahlsäulenachse (22) in einem Winkel ungleich null zur optischen Elektronenmikroskopachse (23) befindet, sodass der Ionenstrahl (21) und der Elektronenstrahl (5) in der Lage sind, sich am gleichen Punkt an der Probe (3) zu treffen.

5. Raman-Mikroskop- und Elektronenmikroskopanalysesystem nach Anspruch 3,
**dadurch gekennzeichnet, dass**
sich die optische Ionenstrahlsäulenachse (22) und die optische Elektronenmikroskopachse (23) in einem Winkel ungleich null zur optischen Raman-Mikroskopachse (15) befinden, sodass der Ionenstrahl (21), der Elektronenstrahl (5) und der Lichtstrahl (12) in der Lage sind, sich am gleichen Punkt an der Probe (3) zu treffen.

6. Raman-Mikroskop- und Elektronenmikroskopanalysesystem nach einem der Ansprüche 1 bis 3,
**dadurch gekennzeichnet, dass**
sich die optische Raman-Mikroskopachse (15) in einem Winkel ungleich null zur optischen Elektronenmikroskopachse (23) befindet, sodass der Lichtstrahl (12) und der Elektronenstrahl (5) in der Lage sind, sich am gleichen Punkt an der Probe (3) zu treffen.

7. Raman-Mikroskop- und Elektronenmikroskopanalysesystem nach einem der Ansprüche 1 bis 5,
**dadurch gekennzeichnet, dass**
die Kammerplattform (2) mit einem Plattformmanipulator (27) verbunden ist, der dazu konfiguriert ist, die Probe (3) aus der ersten Position, in der die optische Raman-Mikroskopachse (15) die Probe (3) schneidet, in die zweite Position, in der die optische Elektronenmikroskopachse (23) die Probe (3) schneidet, zu bewegen.

8. Raman-Mikroskop- und Elektronenmikroskopanalysesystem nach Anspruch 4,
**dadurch gekennzeichnet, dass**
die optische Raman-Mikroskopachse (15) und die optische Elektronenmikroskopachse (23) parallel zueinander sind.

9. Raman-Mikroskop- und Elektronenmikroskopanalysesystem nach einem der vorhergehenden Ansprüche,
**dadurch gekennzeichnet, dass**
das Analysesystem ferner ein Abtastsondenmikroskop (24) umfasst, das einen Abtastsondenmikroskop-Cantilever (25) und eine Abtastsondenmikroskopplattform (26), die auf der Kammerplattform platziert ist, umfasst.

10. Raman-Mikroskop- und Elektronenmikroskopanalysesystem nach Anspruch 9,
**dadurch gekennzeichnet, dass**
der Abtastsondenmikroskop-Cantilever (25) beweglich ist, um eine feine Abtastung der Probe (3) bereitzustellen.

11. Raman-Mikroskop- und Elektronenmikroskopanalysesystem nach Anspruch 9,
**dadurch gekennzeichnet, dass**
die Abtastsondenmikroskopplattform (26) beweglich ist, um eine feine Abtastung der Probe (3) bereitzustellen.

12. Raman-Mikroskop- und Elektronenmikroskopanalysesystem nach einem der vorhergehenden Ansprüche,
**dadurch gekennzeichnet, dass**
das Elektronenmikroskop (4) ein Abtastelektronenmikroskop ist, das mindestens einen Detektor zum Detektieren einer oder mehrerer der Gruppe von sekundären Elektronen, Rückstreuelektronen, Auger-Elektronen, gesendeten Elektronen, Röntgenstrahlen und Photonen umfasst.

13. Raman-Mikroskop- und Elektronenmikroskopanalysesystem nach einem der Ansprüche 1 bis 12,
**dadurch gekennzeichnet, dass**
das Elektronenmikroskop (14) ein Transmissionselektronenmikroskop (4) ist, das mindestens einen Detektor zum Detektieren gesendeter Elektronen umfasst.

## Revendications

1. Système analytique de microscope Raman et de microscope électronique comprenant une chambre à vide (1), une platine de chambre (2) pour supporter un échantillon (3) dans la chambre à vide (1), un microscope électronique (4) ayant un axe optique de microscope électronique (23) pour produire un faisceau d'électrons (5) et le diriger vers l'échantillon (3) et un microscope Raman (6) qui comprend un système de spectroscopie (7), un détecteur de lumière diffusée (8), une source d'illumination (9), une optique de formation de faisceau lumineux (10) et une lentille d'objectif optique (11 ) ayant un axe optique de microscope Raman (15), une lentille d'objectif optique (11) est configurée pour focaliser un faisceau lumineux reçu (12) au niveau de l'échantillon (3) de façon à créer une tache lumineuse (14) au niveau de l'échantillon (3) et à induire une lumière diffusée (16), dans lequel la lentille d'objectif optique (11) est reliée à un manipulateur de lentille d'objectif optique (17) qui est configuré pour déplacer la lentille d'objectif optique (11) dans au moins deux dimensions, une première direction le long de l'axe optique de microscope Raman (15) et une seconde direction dans un plan perpendiculaire à l'axe optique de microscope Raman (15), **caractérisé en ce que**
le manipulateur de lentille d'objectif optique (17) est configuré pour déplacer la lentille optique (11) et pour balayer une zone d'échantillon bidimensionnelle spécifique (3) par la tache lumineuse (14) du faisceau lumineux (12).

2. Système analytique de microscope Raman et de microscope électronique selon la revendication 1,
**caractérisé en ce que**
le système analytique comprend en outre des moyens confocaux pour réduire une lumière diffusée (16) provenant de plans non souhaités hors d'un point focal.

3. Système analytique de microscope Raman et de microscope électronique selon l'une quelconque des revendications précédentes,
**caractérisé en ce que**
le système analytique comprend en outre une colonne de faisceau d'ions (20) ayant un axe optique de colonne de faisceau d'ions (22) pour produire un faisceau d'ions (21) et le diriger vers l'échantillon (3).

4. Système analytique de microscope Raman et de microscope électronique selon la revendication 3,
**caractérisé en ce que**
l'axe optique de colonne de faisceau d'ions (22) forme un angle non nul avec l'axe optique de microscope électronique (23) de sorte que le faisceau d'ions (21) et le faisceau d'électrons (5) peuvent se rencontrer au même endroit au niveau de l'échantillon (3).

5. Système analytique de microscope Raman et de microscope électronique selon la revendication 3,
**caractérisé en ce que**
l'axe optique de colonne de faisceau d'ions (22) et l'axe optique de microscope électronique (23) forment un angle non nul avec l'axe optique de microscope Raman (15) de sorte que le faisceau d'ions (21), le faisceau d'électrons (5) et le faisceau lumineux (12) peuvent se rencontrer au même endroit au niveau de l'échantillon (3).

6. Système analytique de microscope Raman et de microscope électronique selon l'une quelconque des revendications 1 à 3,
**caractérisé en ce que**
l'axe optique de microscope Raman (15) forme un angle non nul avec l'axe optique de microscope électronique (23) de sorte que le faisceau lumineux (12) et le faisceau électronique (5) peuvent se rencontrer au même endroit au niveau de l'échantillon (3).

7. Système analytique de microscope Raman et de microscope électronique selon l'une quelconque des revendications 1 à 5,
**caractérisé en ce que**
la platine de chambre (2) est reliée à un manipulateur de platine (27) qui est configuré pour déplacer l'échantillon (3) de la première position où l'axe optique de microscope Raman (15) coupe l'échantillon (3) à la seconde position où l'axe optique de microscope électronique (23) coupe l'échantillon (3).

8. Système analytique de microscope Raman et de microscope électronique selon la revendication 4,
**caractérisé en ce que**
l'axe optique de microscope Raman (15) et l'axe optique de microscope électronique (23) sont parallèles l'un à l'autre.

9. Système analytique de microscope Raman et de microscope électronique selon l'une quelconque des revendications précédentes,
**caractérisé en ce que**
le système analytique comprend en outre un microscope-sonde à balayage (24) comprenant un porte-à-faux de microscope-sonde à balayage (25) et une platine de microscope-sonde à balayage (26) placée sur la platine de chambre.

10. Système analytique de microscope Raman et de microscope électronique selon la revendication 9,
**caractérisé en ce que**
le porte-à-faux de microscope-sonde à balayage (25) est mobile pour permettre un balayage fin de l'échantillon (3).

11. Système analytique de microscope Raman et de microscope électronique selon la revendication 9,
**caractérisé en ce que**
la platine de microscope-sonde à balayage (26) est mobile pour permettre un balayage fin de l'échantillon (3).

12. Système analytique de microscope Raman et de microscope électronique selon l'une quelconque des revendications précédentes,
**caractérisé en ce que**
le microscope électronique (4) est un microscope électronique à balayage comprenant au moins un détecteur pour détecter un ou plusieurs du groupe des électrons secondaires, des électrons rétrodiffusés, des électrons d'Auger, des électrons transmis, des rayons X et des photons.

13. Système analytique de microscope Raman et de microscope électronique selon l'une quelconque des revendications 1 à 12,
**caractérisé en ce que**
le microscope électronique (14) est un microscope électronique à transmission (4) comprenant au moins un détecteur pour détecter des électrons transmis.
